(19) Europäisches Patentamt
European Patent Office
Office européen des brevets

(11) Veröffentlichungsnummer: **0 384 892 A1**

(12) **EUROPÄISCHE PATENTANMELDUNG**

(21) Anmeldenummer: **90810105.8**

(51) Int. Cl.⁵: **G03F 7/022**

(22) Anmeldetag: **14.02.90**

(30) Priorität: **23.02.89 CH 655/89**

(43) Veröffentlichungstag der Anmeldung: **29.08.90 Patentblatt 90/35**

(84) Benannte Vertragsstaaten: **AT CH DE FR GB IT LI NL SE**

(71) Anmelder: **CIBA-GEIGY AG**
**Klybeckstrasse 141**
**CH-4002 Basel(CH)**

(72) Erfinder: **Schulz, Reinhard, Dr.**
**Im Trappengrund 44**
**D-6107 Reinheim(DE)**
Erfinder: **Münzel, Horst, Dr.**
**Gruobachstrasse 60**
**D-7410 Reutlingen 2(DE)**
Erfinder: **Bartmann, Ekkehard, Dr.**
**Dieburger Weg 12a**
**D-6106 Erzhausen(DE)**

(54) **Photoresist-Zusammensetzungen.**

(57) Photoresist-Zusammensetzung enthaltend 23-27 Gew.-% bezogen auf die Zusammensetzung mindestens einer Verbindung der Formel (I)

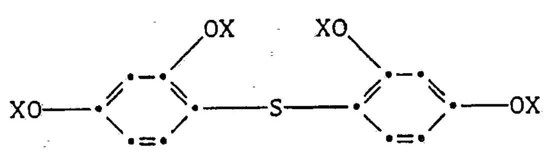

(I),

worin einer der Substituenten X Wasserstoff oder eine Gruppe der Formel II

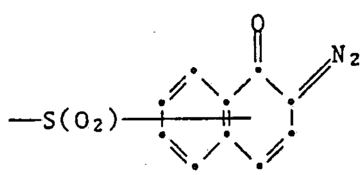

(II)

bedeutet, und die übrigen Substituenten X eine Gruppe der Formel II darstellen; und 6-11 Gew.-% bezogen auf die Zusaammensetzung mindestens einer Polyhydroxyverbindung der Formel III

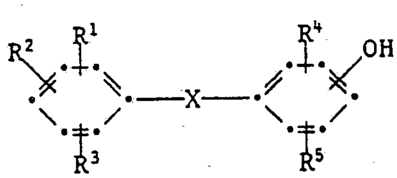

(III),

worin X die direkte Bindung, -O-, -S-, $-SO_2-$, -CO- oder $-C(R^6(R^7)-$ ist, und $R^1$, $R^2$, $R^3$, $R^4$ und $R^5$ unabhängig voneinander Wasserstoff, Halogen, $C_1$-$C_4$-Alkyl, $C_1$-$C_4$-Alkoxy oder Hydroxy bedeuten, und $R^6$

EP 0 384 892 A1

und $R^7$ unabhängig voneinander Wasserstoff, $-CH_3$ oder $-CF_3$ sind.
Diese zeichnen sich besonders durch gute Profilsteilheit und geringe Linienbreitenschwankungen aus.

## Photoresist-Zusammensetzungen

Die vorliegende Erfindung betrifft positiv arbeitende Photoresist-Zusammensetzungen, enthaltend einen Naphthochinondiazidsulfonsäureester und eine aromatische Polyhydroxyverbindung, ein Verfahren zur Erzeugung positiver Abbildungen, sowie die Verwendung dieser Zusammensetzungen als positiv arbeitende Kopierlacke und in der Mikrolithographie zur Herstellung integrierter Schaltungen.

Aus der US-PS 4,626,492 sind positiv arbeitende Photoresists bekannt, welche Sensibilisatoren enthalten, die durch mono-, di- oder tri-Veresterung eines niedermolekularen Phenols mit 1,2-Naphthochinon-2-diazid-5-sulfonylchlorid erhalten werden. Diese Zusammensetzungen enthalten zusätzlich einen Farbstoff und ein Trihydroxybenzophenon.

Die Photoresist-Zusammensetzungen zeichnen sich zwar durch gute Empfindlichkeit aus, genügen aber bezüglich der Qualität (Steilheit) der Resistprofile, der Auflösung und der Linienbreitenänderung der Resistlinien bei Aenderung der Belichtungsenergie, nicht den Anforderungen, welche heutzutage an hochauflösende Photoresist-Materialien gestellt werden.

Aufgabe der Erfindung war es, eine positiv arbeitende Photoresist-Zusammensetzung zu finden, welche sich insbesondere durch gute Profilsteilheit und möglichst geringe Linienbreitenschwankung auszeichnet. Selbstverständlich soll eine solche Zusammensetzung auch gute Empfindlichkeit und Temperaturbeständigkeit besitzen.

Die vorliegende Erfindung betrifft eine positiv arbeitende Photoresist-Zusammensetzung enthaltend 23-27 Gew.-% bezogen auf die Zusammensetzung mindestens einer Verbindung der Formel (I)

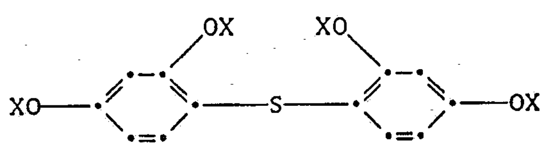

(I),

worin einer der Substituenten X Wasserstoff oder eine Gruppe der Formel II

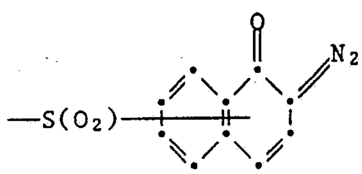

(II)

bedeutet, und die übrigen Substituenten X eine Gruppe der Formel II darstellen; und

6-11 Gew.-% bezogen auf die Zusammensetzung mindestens einer Polyhydroxyverbindung derFormel III

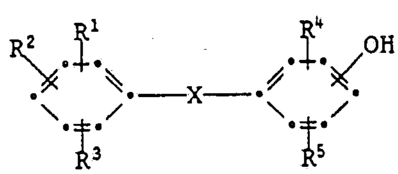

(III),

worin X die direkte Bindung, -O-, -S-, $-SO_2-$, -CO- oder $-C(R^6(R^7)-$ ist, und $R^1$, $R^2$, $R^3$, $R^4$ und $R^5$ unabhängig voneinander Wasserstoff, Halogen, $c_1$-$C_4$-Alkyl, $C_1$-$C_4$-Alkoxy oder Hydroxy bedeuten, und $R^6$ und $R^7$ unabhängig voneinander Wasserstoff, $-CH_3$ oder $-CF_3$ sind.

Die Verbindungen der Formel I sind bekannt und z.B. in der DE-AS 11 18 606 beschrieben. Diese lichtempfindlichen Ester werden in an sich bekannter Weise durch Umsetzung, besonders der Sulfonsäurechloride, der Naphthochinon-(1,2)-diazidsulfonsäuren mit 2,4,2′4′-Tetrahydroxydiphenylsulfid hergestellt. Als Naphthochinon-(1,2)-diazidsulfonsäureester kommen besonders diejenigen in Frage, die sich von der Naphthochinon-(1,2)-diazid-(2)-sulfonsäure-(4) und insbesondere von der Naphthochinon-(1,2)-diazid(2)-sulfonsäure-(5) herleiten. Zur Herstellung der Ester werden die beiden Komponenten (wobei die Sulfonsäuren

meistens als Sulfonsäurechlorid eingesetzt werden) üblicherweise in einem Lösungsmit tel, wie Dioxan, Tetrahydrofuran, Dimethylformamid, Diethylenglykoldimethylether oder Glykolmonomethylether gelöst und durch Zugabe von schwachen Alkalien, wie z.B. Alkalibicarbonaten, Alkalicarbonaten der Aminoverbindungen, wie z.B. Triethylamin, verestert. Die so erhaltenen Sulfonsäureester können tel quel in den Photoresist-Zusammensetzungen eingesetzt werden oder auf an sich bekannte Weise, z.B. in einem geeigneten Lösungsmittel, wie Dioxan, und anschliessendem Zugeben von Wasser umgefällt und gereinigt werden. Durch die Menge der angewandten Naphthochinon-(1,2)-diazid-sulfonsäurechloride hat man es in der Hand drei oder alle Hydroxylgruppen des 2,4,2′,4′-Tetrahydroxydiphenylsulfids zu verestern. Bevorzugt werden etwa drei Mol Naphthochinon-(1,2)-diazid sulfonsäurechlorid pro Mol 2,4,2′,4′-Tetrahydroxydiphenylsulfid eingesetzt.

Die Verbindungen der Formel III sind ebenfalls bekannte Verbindungen und zum Teil im Handel erhältlich. Solche aromatischen Polyhydroxyverbindungen sind beispielsweise in der DE-A 37 24 791 beschrieben.

Die Verbindungen der Formel III enthalten mindestens zwei Hydroxylgruppen. Die Reste $R^1$, $R^2$, $R^3$, $R^4$ und $R^5$ können, sofern sie nicht Wasserstoff bedeuten, Halogen, wie Fluor, Chlor, Brom; $C_1$-$C_4$-Alkyl, wie Methyl, Ethyl, n- oder i-Propyl, n-, sec.- oder tert.-Butyl oder $C_2$-$C_4$-Alkoxy, wie Methoxy, Ethoxy, n-, i-Propoxy; n-, sec.- oder tert.-Butoxy sowie Hydroxy sein.

Vorzugsweise enthalten die Verbindungen der Formel III zwei oder drei OH-Gruppen und sonst keine Substituenten. Die OH-Gruppen besetzen bevorzugt die 4,4′-; die 2,2′- oder die 2,3,4-Position. Geeignete Verbindungen der Formel III sind 4,4′-Dihydroxybiphenyl; 2,2′-Dihydroxybiphenyl; 4,4′-Dihydroxybenzophenon; Bis-(4-hydroxyphenyl)-ether; Bis-(4-hydroxyphenyl)sulfid; Bis-(4-hydroxyphenyl)-propan.

Besonders bevorzugt sind Trihydroxybenzophenone, wie sie beispielsweise in der US-PS 4,626,492 beschrieben sind, nämlich 2,4,4′-Trihydroxybenzophenon oder 2,4,6-Trihydroxybenzophenon und ganz besonders 2,3,4-Trihydroxy-Benzophenon.

Es hat sich gezeigt, dass die eingesetzten Mengen der Verbindungen der Formel I und III von grosser Bedeutung für die Verarbeitbarkeit und die Qualität des Photoresist-Materials ist.

Diese Mengen dürfen nur in engen Bereichen variieren, will die geforderte Qualität erreicht werden. Verlässt man diese Bereiche, so muss mit einer Einbusse, insbesondere bezüglich Kantensteilheit (Kontrast) und Linienbreitenschwankung gerechnet werden.

Diese Bereiche liegen für die Verbindungen der Formel I bei 23-27 Gew.-% bezogen auf die gesamte Photoresist-Zusammensetzung, und vorzugsweise bei 24-26 Gew.-%; und für die Verbindungen der Formel III bei 6-11 Gew.-% und vorzugsweise 6-10 Gew.-%. Wird in diesem Zusammenhang von Gew.-% gesprochen, so sind diese Angaben auf den Gesamtfeststoffgehalt der Zusammensetzung bezogen.

Die für die technische Anwendbarkeit wesentlichen Merkmale eines Photoresist sind Strahlungsempfindlichkeit, Bildauflösung und Kontrast.

Eine hohe Empfindlichkeit ist wichtig, um in den produktionstechnischen Prozesszyklen kurze Bestrahlungszeiten zu gewährleisten, auch etwa, wenn gerätetechnisch bedingt nur Strahlung geringerer Intensität, beispielsweise bei monochromatischer Belichtung, auf den Resist einwirken kann.

Die Bildauflösung charakterisiert, bis zu welchen Dimensionen kleinste Bildstrukturen der Vorlage, wie etwa Linien und Zwischenräume, klar getrennt und massgetreu durch den Photoresist in Form von Stegen und Gräben wiedergegeben werden können. Die Herstellung von VLSI-Schaltungen erfordert die Wiedergabe von Strukturdetails in der Grössenordnung von 1 $\mu$m und weniger.

Der Kontrast charakterisiert die Kantensteilheit und Kantenschärfe der nach Entwicklung erhaltenen Photoresist-Reliefstrukturen. Diese sollten möglichst scharfkantig sein und im Idealfall 90°-Flanken aufweisen.

Die bei der Erzeugung von Photoresist-Strukturen erzielbare Auflösung ist in erster Linie abhängig von den materialspezifischen Eigenschaften des Photoresist, wie insbesondere Absorption und Quantenausbeute der reaktionsauslösenden Strahlung sowie Entwicklungsverhalten; sie findet ihre untere Grenze in der optischen Qualität der Belichtungsgeräte und theoretisch durch die Wellenlänge der verwendeten Strahlung. Optiken, die für höchste Ansprüche bei monochromatischer Belichtung ausgelegt sind, müssen eine hohe numerische Apertur aufweisen. Mit steigender numerischer Apertur sinkt jedoch die Schärfentiefe und damit der für eine Anwendung unter Produktionsbedingungen erforderliche Fokussierungsspielraum erheblich. Die Erzielung höherer Auflösungen durch die Anwendung von Strahlung kleinerer Wellenlänge, wie etwa Tief-UV oder Röntgen-Strahlung ist mit den gängigen Positiv-Photoresists wegen ihrer photochemischen Eigenschaften und mit den üblichen, im nahen UV mit Strahlung des Quecksilber-Spektrums arbeitenden Belichtungsgeräten nicht möglich. Einer Auflösungssteigerung mit optischen Massnahmen sind somit praktische Grenzen gesetzt.

Die derzeit üblichen Positiv-Photoresists auf Basis von alkalilöslichem Harz und Naphthochinondiazid-Verbindungen ermöglichen bei Belichtung im nahen UV mit Objektiven einer numerischen Apertur von 0,3-0,4 eine Auflösung bis herab zu 0,8-0,9 µm. Bei der Forderung nach immer höherer Integrationsdichte auf Mikrochips besteht daher ein grosser Bedarf an höher auflösenden Positiv-Photoresists, die im nahen UV strukturierbar sind und insbesondere in den in der Massenproduktion in grossem Umfang eingesetzten Wafer-Steppern, die überwiegend monochromatisch mit der Strahlung der Quecksilber-G-Linie (436 nm) arbeiten, verarbeitet werden können. Für den Submikrometerbereich gilt hierbei eine Auflösungsverbesserung um 0,1-0,3 µm gegenüber dem Stand der Technik als erheblich. Es bestand daher die Aufgabe, Positiv-Photoresists nach dem Stand der Technik dahingehend zu verbessern, dass sie im nahen UV eine deutlich gesteigerte Auflösung zeigen und auch im Bereich höchster Auflösung Strukturen hoher Kantenschärfe und Kantensteilheit liefern.

Photoresist-Zusammensetzungen sind in zahlreichen Veröffentlichungen beschrieben worden, z.B. in DeForest, "Photoresist Materials and Processes", McGraw-Hill Book Company, N.Y., 1975. Diese umfassen aus einer Lösung hergestellte Ueberzüge oder als Trockenfilm aufgetragene Ueberzüge. Der positiv arbeitende Resist wird nach Belichtung durch aktivierende Strahlung im Entwickler löslich.

Die positiv arbeitenden Photoresists bestehen im wesentlichen aus einer Lichtempfindlichen Verbindung in einem filmbildenden polymeren Bindemittel. Es kann sich dabei um physikalische Mischungen oder um Umsetzungsprodukte, sogenannte Diazoharze handeln. Die am häufigsten verwendeten lichtempfindlichen Verbindungen oder Sensibilisatoren sind als Chinondiazide bekannt geworden. Es handelt sich dabei vor allem um Ester und Amide von o-Chinondiazid-carbonsäuren und insbesondere -sulfonsäuren. Geeignete Sensibilisatoren dieser Art sind beispielsweise beschrieben in DeForest (a.a.O., s.S. 47-55) und den folgenden US-PSen: 2,754,209; 3,046,110; 3,046,112;3,046,113; 3,046,116; 3,046,118; 3,046,119, 3,046,120; 3,647,443; 3,759,711 oder 4,141,733. Bevorzugt handelt es sich dabei um Naphthochinondiazide, und insbesondere um o-Naphthochinon(4- oder 5-)sulfonsäure-Derivate. Dabei werden die monomeren Chinondiazid-sulfonsäuren in Form ihrer Ester oder Amide in das Bindemittel eingearbeitet oder man lässt z.B. ein Chinondiazid-sulfonsäurechlorid mit dem Bindemittel reagieren, wie es etwa in der US-PS 4,141,733 oder der GB-PS 1,546,633 beschrieben ist. Letztere werden Diazoharze genannt.

Die Wahl des Bindemittels erfolgt je nach Anwendungsgebiet und den hierfür geforderten Eigenschaften. Eine Zusammenstellung möglicher Harze findet sich bei DeForest (a.a.O., S. 57-59).

Besonders geeignete Bindemittel sind beispielsweise Novolake, die sich von einem Aldehyd, vorzugsweise Acetaldehyd oder Formaldehyd, insbesondere jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise p-Chlorphenol, oder sie ist ein durch ein bis zwei $C_1$-$C_9$-Alkylgruppen substituiertes Phenol, beispielsweise o-, m- oder p-Kresol, ein Xylenol, p-tert.Butylphenol oder p-Nonylphenol. Es kann sich bei der Phenolkomponente der bevorzugten Novolake aber auch um p-Phenylphenol, Resorcin, Bis-(4-hydroxyphenyl)-methan oder 2,2-Bis-(4-hydroxyphenyl)-propan handeln.

Ein Teil der phenolischen Hydroxygruppen dieser Novolake kann gegebenenfalls durch Umsetzung z.B. mit Chloressigsäure, Isocyanaten, Epoxiden oder Carbonsäureanhydriden modifiziert sein.

Weitere geeignete Bindemittel sind beispielsweise Polyvinylphenole oder Copolymere von Maleinsäureanhydrid mit Styrol oder Vinylethern oder 1-Alkenen, bzw. Copolymere von Hydroxy- oder Aminostyrol mit Styrol, Vinylacetat usw.

Ebenfalls als Bindemittel einsetzen lassen sich Copolymere von Estern der Acrylsäure oder Methacrylsäure mit ethylenisch ungesättigten Säuren, beispielsweise Methacrylsäure oder Acrylsäure.

Mit dem Ausdruck Diazoharz werden Bindemittel bezeichnet, welche lichtempfindliche Chinondiazid-Substituenten tragen. Es handelt sich also nicht um physikalische Gemische aus lichtunempfindlichen Bindemitteln und lichtempfindlichen Verbindungen, sondern um lichtempfindliche Bindemittel, welche durch Umsetzung eines lichtunempfindlichen Bindemittels mit einer lichtempfindlichen Verbindung, insbesondere einem reaktionsfähigen Chinondiazids, z.B. einem o-Naphthochinondiazid-sulfochlorid erhalten werden können. Solche Diazoharze sind z.B. in der US-PS 3,046,120; der US-PS 4,141,733, GB-PS 1,026,144, GB-PS 1,113,759; DE-PS 18 03 712, DE-PS 19 11 497 oder der CA-PS 903,545 beschrieben und können nach den dort beschriebenen Methoden hergestellt werden.

Besonders geeignet für die Umsetzung mit einem lichtempfindlichen reaktionsfähigen Chinondiazid, z.B. mit o-Naphthochinondiazid-(4-oder 5-)sulfochlorid sind Phenol- oder Kresolformaldehydharze, Polyvinylphenole oder Amino- bzw. Hydroxystyrol-Copolymere z.B. mit Styrol, Vinylacetat u.ä.

Den alkalilöslichen Bindemitteln bzw. Diazoharzen können gegebenenfalls noch weitere Zusatzharze beigegeben werden, wie es bei den Positiv-Systemen üblich ist. Zu diesen Zusatzharzen zählen beispielsweise Vinylpolymerisate, wie Polyvinylacetat, Polyacrylate, Poly-(methacrylsäurealkylester) oder Poly(acrylsäure/alkylester), wobei mit Alkyl $C_1$-$C_{20}$-Alkyl gemeint ist, Polyvinylether oder Polyvinylpyrrolidone.

Im allgemeinen werden jedoch nicht mehr als 20 Gew.-%, bezogen auf die Menge an alkalilöslichem Bindemittel, von diesen Zusatzharzen zugefügt.

Die erfindungsgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie von Metallen, wie Al, Cu, Ni, Fe, Zn, Mg oder Co, und von Si oder $SiO_2$, bei denen durch bildmässiges Belichten eine Abbildung aufgebracht werden soll. Ein weiterer Gegenstand vorliegender Erfindung sind die beschichteten Substrate.

Die Erfindung betrifft ferner auch ein Verfahren zur Erzeugung von positiven Abbildungen, umfassend folgende Arbeitsschritte:

a) Beschichtung eines Substrates mit einer strahlungsempfindlichen Zusammensetzung wie oben definiert,

b) Belichtung des beschichteten Substrates mit einem vorbestimmten Muster aktinischer Strahlung, und

c) Entwicklung des belichteten und beschichteten Substrates.

Die Herstellung der beschichteten Substrate kann z.B. erfolgen, indem man eine Lösung oder Suspension der Zusammensetzung herstellt. Die Wahl des Lösungsmittels und die Konzentration richtet sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in weit variablen Schichtdicken eingesetzt werden können.

Mögliche Einsatzgebiete der erfindungsgemässen Zusammensetzungen sind die Verwendung als Photoresists für die Elektronik (Galvanoresist, Aetzresist), die Herstellung von Druckplatten, wie Offsetdruckplatten für den autotypischen Tiefdruck oder für den Rollodruck und ferner für die Herstellung von Siebdruckformen, der Einsatz beim Formteilätzen oder der Einsatz als Mikroresist bei der Herstellung integrierter Schaltkreise in der Mikroelektronik.

Dementsprechend unterschiedlich sind die möglichen Schichtträger und die Verarbeitungsbedingungen der beschichteten Substrate.

Für photographische Informationsaufzeichnung dienen z. B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate.

Nach Beschichten wird das Lösungsmittel in der Regel durch Trocknen entfernt und es resultiert eine Schicht des Photoresist auf dem Träger.

Nach der in üblicher Weise erfolgten bildmässigen Belichtung des Materials werden die belichteten Stellen des Photolackes durch Herauslösen in einem Entwickler entfernt.

Besonders bevorzugt als Entwickler werden wässrig alkalische Lösungen, wie sie für die Entwicklung von Naphthochinondiazid-Novolak-Resists eingesetzt werden. Dazu zählen insbesondere wässrige Lösungen von Alkalimetallsilikaten, -phosphaten und -hydroxiden oder Tetraalkylammoniumverbindungen. Diese Lösungen können gegebenenfalls noch kleinere Mengen an Netzmitteln und/oder organischen Lösungsmitteln und anderen Additiven zugesetzt sein.

Typische organische Lösungsmittel, sind solche, die mit Wasser mischbar sind und den Entwicklerflüssigkeiten zugesetzt werden können, wie beispielsweise 2-Ethoxyethanol oder Aceton, sowie Mischungen zweier oder mehrerer solcher Lösungsmittel.

Der Begriff 'Belichtung mit einem vorbestimmten Muster aktinischer Strahlung' beinhaltet sowohl die Belichtung durch eine Photomaske, die ein vorbestimmtes Muster enthält, beispielsweise eine Chrommaske oder ein Diapositiv, sowie die Belichtung durch einen Laserstrahl, der beispielsweise computergesteuert über die Oberfläche des beschichteten Substrates bewegt wird, und auf diese Weise ein Bild erzeugt.

Die Lichtempfindlichkeit der erfindungsgemässen Zusammensetzungen reicht in der Regel vom UV-Gebiet (ca. 250 nm) bis ca. 600 nm und umspannt somit einen sehr breiten Bereich. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Der Abstand zwischen Lampen und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohen Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Die lichtempfindlichen Zusammensetzungen können gegebenenfalls auch Sensibilisatoren enthalten, um die spektrale Empfindlichkeit in einem bestimmten Bereich des elektromagnetischen Spektrums zu erhöhen.

Die Erfindung betrifft daher auch die Verwendung der Zusammensetzungen, wie oben definiert, als Positiv-Photoresists für die Herstellung von positiv arbeitenden Kopierlacken, welche z.B. zur Herstellung von integrierten Schaltungen, Aetzreserven, Offsetdruckplatten, Farbprüffolien, Schablonen, Namensschilder etc. dienen.

Beispiele 1-3

Photoresist-Zusammensetzung I (Beispiel 1)
66,0 Gew.-% m-Kresol-Novolak-Harz (M $\overline{w}$ = 9000)
25,0 Gew.-% Veresterungsprodukte aus 1 Teil 2,4,2',4'-Tetrahydroxydiphenylsulfid mit 3 Teilen Naphthochinondiazid-5-sulfonylchlorid
9,0 Gew.-% 2,3,4-Trihydoxybenzophenon.

Photoresist-Zusammensetzung II (Beispiel 2)
65,9 Gew.-% m-Kresol-Novolak-Harz (M $\overline{w}$ = 9000)
25,0 Gew.-% des in Beispiel 1 angegebenen Naphthochinondiazid-Reaktionsprodukts
9,0 Gew.-% 2,3,4-Trihydroxybenzophenon
0,1 Gew.-% Farbstoff Curcumin (s. z.B. EP-A 200 129).

Photoresist-Zusammensetzung III (Beispiel 3)
69,0 Gew.-% m-Kresol-Novolak-Harz (M $\overline{w}$ = 9000)
25,0 Gew.-% des in Beispiel 1 angegebenen Naphthochinondiazid-Reaktionsprodukts
6,0 Gew.-% 2,3,4-Trihydroxybenzophenon.

Aus diesen Zusammensetzungen wurden 35% ige Lösungen in Diethylenglykoldimethylether hergestellt und diese durch Filter mit 0,2 µm Porenweite filtriert.

Die so erhaltenen Photoresist-Lösungen werden während 30 Sekunden auf Silizium-Scheiben von 100 mm Durchmesser bei 5000 U/min aufgeschleudert. Die so erhaltene gleichmässige Schichtdicke beträgt 1,5 µm. Die beschichteten Wafer werden für 1 min bei 100 °C auf einer Heizplatte vorgetrocknet und mit monochromatischer UV-Strahlung der Wellenlänge 436 nm mit einem Waferstepper (Canon FPA 1550, numerische Apertur = 0,35) bildmässig durch eine Testmarke belichtet. Das Testmuster besteht aus Linien und Zwischenräumen (Gitter) verschiedener Abmessungen von 3,0 µm bis 0,5 µm.

Die Belichtungsenergie wird von 100-300 $mJ/cm^2$ stufenweise variiert. Die belichteten Wafer werden danach während 1 min bei 115 °C nachgetrocknet ("Post-Exposure-Bake") und anschliessend während 1 min in 2,4% iger wässriger Tetramethylammoniumhydroxid-Lösung entwickelt.

Die so erhaltenen Resist-Schichten werden mit Gold besputtert und die 0,7; 0,8; 0,9 und 1,0 µm-Gitterstrukturen elektronenmikroskopisch vermessen und beurteilt.

Als Beurteilungskriterien dient die Qualität (Kantensteilheit) der Resistprofile, die Auflösung und die Linienbreitenänderung von 1,0 µm-Resistlinien bei 10 % Aenderung der Belichtungsenergie relativ zur Dosis, die gerade für die masshaltige Abbildung von 1,0 µm-Linien erforderlich war.

Die Resultate sind in der untenstehenden Tabelle A zusammengestellt:

Tabelle A

| Bsp. Nr. | Auflösung | Profilsteilheit | Linienbreitenschwankung |
|---|---|---|---|
| 1 | 0,7 µm | gut | 0,06 µm |
| 2 | 0,7 µm | gut | 0,06 µm |
| 3 | 0,7 µm | gut | 0,06 µm |

Beispiele 4 und 5

Auf analoge Weise wurden die folgenden Zusammensetzungen getestet:

Photoresist-Zusammensetzung IV (Beispiel 4)

68,0 Gew.-% m-Kresol-Novolak-Harz ($\overline{M}_{w}$ = 9000)
22,0 Gew.-% des in Beispiel 1 angegebenen Naphthochinondiazid-Reaktionsprodukts
10,0 Gew.-% 2,3,4-Trihydroxybenzophenon.

Photoresist-Zusammensetzungen V (Beispiel 5)

67,9 Gew.-% m-Kresol-Novolak-Harz ($\overline{M}_{w}$ = 9000)
22,0 Gew.-% des in Beispiel 1 angegebenen Naphthochinondiazid-Reaktionsprodukts
10,0 Gew.-% 2,3,4-Trihydroxybenzophenon
0,1 Gew.-% Farbstoff Curcumin (s. z.B. EP-A 200 129).

Die Resultate sind in der untenstehenden Tabelle B zusammengestellt:

Tabelle B

| Bsp. Nr. | Auflösung | Profilsteilheit | Linienbreitenschwankung |
|---|---|---|---|
| 4 | 0,8 µm | befriedigend | 0,09 µm |
| 5 | 0,9 µm | befriedigend | 1,00 µm |

Diese Resultate zeigen deutlich, dass Zusammmensetzungen, welche die Verbindungen der Formel I nicht in den anspruchsgemässen Mengen enthalten, den erfindungsgemässen Photoresist-Zusammensetzungen bezüglich Auflösung, Profilsteilheit und besonders auch bezüglich Linienbreitenschwankungen deutlich unterlegen sind.

**Ansprüche**

1. Photoresist-Zusammensetzung enthaltend 23-27 Gew.-% bezogen auf die Zusammensetzung mindestens einer Verbindung der Formel (I)

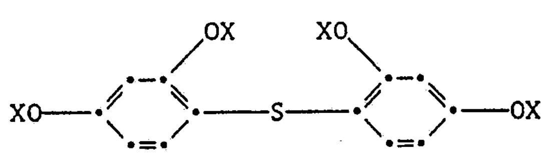

(I),

worin einer der Substituenten X Wasserstoff oder eine Gruppe der Formel II

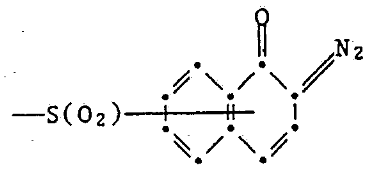

(II)

bedeutet, und die übrigen Substituenten X eine Gruppe der Formel II darstellen; und 6-11 Gew.-% bezogen auf die Zusaammensetzung mindestens einer Polyhydroxyverbindung der Formel III

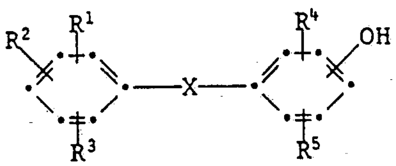

(III),

worin X die direkte Bindung, -O-, -S-, $-SO_2-$, -CO- oder $-C(R^6(R^7)-$ ist, und $R^1$, $R^2$, $R^3$, $R^4$ und $R^5$ unabhängig voneinander Wasserstoff, Halogen, $C_1$-$C_4$-Alkyl, $C_1$-$C_4$-Alkoxy oder Hydroxy bedeuten, und $R^6$ und $R^7$ unabhängig voneinander Wasserstoff, $-CH_3$ oder $-CF_3$ sind.

2. Zusammensetzungen gemäss Anspruch 1, wobei in Formel I einer der Substituenten X Wasserstoff und die übrigen eine Gruppe der Formel II darstellen.

3. Zusammensetzungen gemäss Anspruch 1, wobei in Formel I die Substituenten X eine Gruppe der Formel II darstellen.

4. Zusammensetzungen gemäss Anspruch 1, wobei die Formel II der Struktur

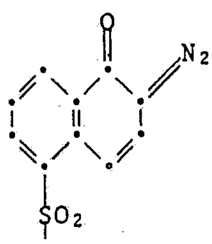

(II*)

entspricht.

5. Zusammensetzungen gemäss Anspruch 1, wobei die Formel II der Struktur

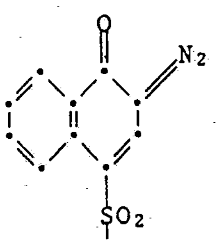

(II**)

entspricht.

6. Zusammensetzungen gemäss Anspruch 1, wobei in Formel II, die Reste $R^1$, $R^2$, $R^3$ $R^4$ und $R^5$ Hydroxy sind.

7. Zusammensetzungen gemäss Anspruch 6, enthaltend ein Trihydroxybenzophenon.

8. Zusammensetzungen gemäss Anspruch 7, enthaltend 2,3,4-Trihydroxybenzophenon.

9. Zusammensetzungen gemäss Anspruch 1, wobei die Formel III der Struktr

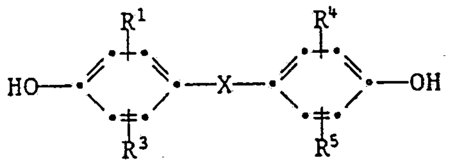

(III*)

entspricht.

10. Zusammensetzungen gemäss Anspruch 1, enthaltend 50-75 Gew.-% bezogen auf die Zusammensetzung eines Bindemittels.

11. Zusammensetzungen gemäss Anspruch 9, enthaltend als Bindemittel ein Novolak-Harz.

12. Verfahren zur Herstellung positiver Abbildungen umfassend folgende Arbeitsschritte:

- Beschichten eines Substrats mit einer strahlungsempfindlichen Zusammensetzung gemäss Anspruch 1,
- Belichten des beschichteten Substrats mit einem vorbestimmten Muster aktinischer Strahlung, und
- Entwicklung des belichteten Substrates.

Europäisches Patentamt

# EUROPÄISCHER RECHERCHENBERICHT

Nummer der Anmeldung

EP 90 81 0105

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| D,Y | US-A-3184310 (FRITZ G.,SUS O., UHLIG F. AND NEUGEBAUER W.)<br>* das ganze Dokument *<br>--- | 1-12 | G03F7/022 |
| D,Y | EP-A-301332 (CIBA-GEIGY AG)<br>* das ganze Dokument *<br>--- | 1-12 | |
| D,Y | US-A-4626492 (EILBECK J.N.)<br>* Spalte 2, Zeile 44 - Spalte 3, Zeile 24 *<br>* Spalte 4, Zeilen 52 - 68 *<br>--- | 1-12 | |
| A | EP-A-55814 (HOECHST AG)<br>* Seite 6, Zeile 11 - Seite 7, Zeile 18; Ansprüche 1-9 *<br>--- | 1-12 | |
| A | EP-A-1254 (HOECHST AG)<br>*Beispiele, Patentansprüche*<br>----- | 1-12 | |
| | | | RECHERCHIERTE SACHGEBIETE (Int. Cl.5 ) |
| | | | G03F7/00 |

Der vorliegende Recherchenbericht wurde für alle Patentansprüche erstellt

| Recherchenort | Abschlußdatum der Recherche | Prüfer |
|---|---|---|
| DEN HAAG | 07 JUNI 1990 | LUDI M.M.B. |

3

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes Dokument

EPO FORM 1503 03.82 (P0403)